Europäisches Patentamt

European Patent Office

Office européen des brevets

(19)

(11) Publication number: **0 042 380**

**B1**

(12) **EUROPEAN PATENT SPECIFICATION**

(45) Date of publication of patent specification: **19.03.86**

(21) Application number: **80901014.3**

(22) Date of filing: **28.12.79**

(86) International application number:
**PCT/US79/01137**

(87) International publication number:
**WO 81/01911 09.07.81 Gazette 81/16**

(51) Int. Cl.⁴: **H 01 L 21/22, H 01 L 21/265, H 01 L 21/20**

(54) **METHOD FOR ACHIEVING IDEAL IMPURITY BASE PROFILE IN A TRANSISTOR.**

(43) Date of publication of application:
**30.12.81 Bulletin 81/52**

(45) Publication of the grant of the patent:
**19.03.86 Bulletin 86/12**

(84) Designated Contracting States:
**DE FR GB**

(56) References cited:
**DE-A-2 160 426**
**US-A-3 083 441**
**US-A-3 389 023**
**US-A-3 432 920**
**US-A-3 489 622**
**US-A-3 635 772**
**US-A-3 717 507**
**US-A-3 753 807**
**US-A-3 856 578**
**US-A-3 880 676**
**US-A-3 886 569**
**US-A-3 940 288**
**US-A-4 066 473**
**US-A-4 115 797**
**US-A-4 157 269**
**US-A-4 168 999**

(73) Proprietor: **International Business Machines Corporation**
**Old Orchard Road**
**Armonk, N.Y. 10504 (US)**

(72) Inventor: **CROWDER, Billy Lee**
**Oscawana Lake Road**
**Putnam Valley, NY 10579 (US)**
Inventor: **ISAAC, Randall Duane**
**3162 Wharton Drive**
**Yorktown Heights, NY 10598 (US)**
Inventor: **MING, Tak Hung**
**1720 Maxwell Drive**
**Yorktown Heights, NY 10598 (US)**

(74) Representative: **Oechssler, Dietrich, Dr. rer. nat.**
**Schönaicher Strasse 220**
**D-7030 Böblingen (DE)**

(56) References cited:
**IBM Technical Disclosure Bulletin, Volume 20, No. 11A Issued 1978 April, "Producing A Transistor With An Optimum Concentration Profile" By Briska et al**

Courier Press, Leamington Spa, England.

**0 042 380**

(56) References cited:

**IBM TECHNICAL DISCLOSURE BULLETIN, vol. 22, no. 4, September 1979 NEW YORK (US) I.**

**ANTIPOV: "Process for separate control of intrinsic and extrinsic base doping in semiconductor device fabrication", pages 1467-68**

# Description

## Technical field

This invention relates to a method for fabricating a bipolar transistor to obtain a desired ideal base impurity concentration profile, and more particularly to the use of separate and independent diffusion or ion implantation steps to form the extrinsic and intrinsic base regions of the transistor.

## Background art

Bipolar transistors have been fabricated using both diffusion and ion implantation steps in order to provide the desired impurity profile in the transistor. In particular, ion implantation is a technique which provides a wide range of impurity concentrations with a high degree of control of both the impurity concentration and its distribution. For this reason, the prior art has attempted to fabricate high frequency transistors using ion implantation, either in a double implant process wherein both the emitter and base regions are implanted in the semiconductor substrate, or in hybrid processes wherein the base is implanted and the emitter diffused.

In the prior art, bipolar transistors have been fabricated using two separate processing steps to form the base region. For example, U.S. 3,856,578 describes a process having a first step comprising diffusion or ion implantation to determine the sheet resistivity at the surface of a semiconductor, followed by a second step in which impurities are implanted within the same area of the semiconductor material, but to a greater depth than the impurities introduced in the first step. In this manner, the impurity profile is dominated at the surface by impurities determining sheet resistivity, and is dominated in the bulk of the semiconductor material by the impurities introduced in the second step. The emitter region is later formed by a chemical diffusion step, or by ion implantation together with thermal diffusion of the implanted impurities.

Another method for obtaining a bipolar transistor having a specified concentration profile is that described in IBM Technical Disclosure Bulletin Vol. 20, No. 11A, Page 4452, April 1978. In that technique, the impurity profile of the collector-base junction is adjusted to obtain a desired impurity profile by subsequent boron implantation.

In a bopolar transistor, it is desirable that the extrinsic base portion be doped more heavily than the intrinsic base portion and that the emitter be doped more heavily than either of the two base portions. A high peak impurity concentration in the extrinsic base region reduces the extrinsic base resistance and minimizes emitter sidewall injection. The intrinsic base concentration profile is determinted only by the desired intrinsic base characteristics, regardless of the impurity profile of the extrinsic base. In ion implantation of the intrinsic base region, it is desired to minimize the amount of post ion implantation heat treatment that is required, in order to maintain the profile produced by the implantation.

These prior art methods are two-step processes for forming the intrinsic and extrinsic base regions, these two steps follow one another, so that the two steps are additive. Thus, the steps wherein the intrinsic and extrinsic base regions are formed are not truly separate from one another, and processing tolerance is therefore more tight.

From US—A—4 157 269 there is known a method for forming a transistor in a wafer of semiconductor material having a collector region therein of a first conductivity type, including the steps of: forming a doped polycrystalline layer of said semiconductive material of the opposite conductivity type to said collector region over a surface of said semiconductor wafer; forming extrinsic base regions of said transistor; forming an intrinsic base region and an emitter region through a window in said polycrystalline layer or through an opening in an oxide layer formed in said window respectively, said emitter having the same conductivity type as said collector, said intrinsic base region having the same conductivity type as said extrinsic base region; opening contact holes to said layer of polycrystalline semiconductor material, and contacting said extrinsic base region by metal contacts which contact said layer of polycrystalline material, and depositing a metal layer which electrically contacts said emitter region.

In the article "Process for Separate Control of Intrinsic and Extrinsic Base Doping in Semiconductor Device Fabrication" by I. Antipov published in the IBM Technical Disclosure Bulletin Vol. 22, No. 4, 9—1979, p. 1467, a process is described in which the intrinsic and the extrinsic base region are formed separately by forming a base region, etching an opening penetrating said base region and by forming an emitter and an intrinsic base region in said opening with the base region being formed in the beginning serving as the extrinsic base region. In the methods described in the article of Antipov or in US—A—4 157 269 respectively the emitter and base contacts are not self-aligned with one another.

It is a primary object of the present invention to provide an improved method for obtaining a desired ideal impurity profile in a bipolar transistor.

It is another object of the present invention to provide a process for making a bipolar transistor having self-aligned emitter and base contacts, and wherein the extrinsic and intrinsic base regions are formed by separate steps.

It is another object of this invention to provide an ion implantation technique for porducing a bipolar transistor, in which first and second ion implantation steps can be used, wherein the effects of the first implantation step are removed from the area which is to be subject to the second ion implantation step.

## Disclosure of invention

This invention relates to a process for making a bipolar transistor, and particularly to a process in which the intrinsic base region and extrinsic base region are formed separately, in order to yield a transistor having an ideal implanted base impurity concentration profile and in which the emitter and base contacts are self-aligned with one another.

The process includes the steps of forming a doped polycrystalline layer of said semiconductive material of the opposite conductivity type to said collector region over a surface of said semiconductor wafer, forming a base region of opposite conductivity type to said first conductivity type in said wafer of semiconductor material, portions of said base region being extrinsic base regions of said transistor, masking a portion of said base region to expose an area thereof to be removed by an etching step, etching said base region in said exposed area to remove said base region in said exposed area, creating a window therein, thereby exposing a portion of said surface of said semiconductor wafer, there being a portion of said base region left which is said extrinsic base region, forming an emitter region and an intrinsic base region through said window in said base region, said emitter having the same conductivity type as said collector, said intrinsic base region having the same conductivity type as said extrinsic base region, opening contact holes to said layer of polycrystalline semiconductor material, and contacting said extrinsic base region by metal contacts which contact said layer of polycrystalline material, and depositing a metal layer which electrically contacts said emitter region.

The use of a polycrystalline layer for contacting the extrinsic base region allows self-alignment of the emitter and base contacts in a later process step. The etching step in which the effect of the first ion implantation or diffusion is removed in the region of the intrinsic base does not contaminate the underlying semiconductor surface and therefore the emitter and intrinsic base region are reliably produced. Furthermore, the etched region is subsequently heavily doped and consequently does not have any exposed or depleted surface region. For these reasons, there is no adverse effect due to the etching step, as might be anticipated by those having skill in this art.

Since the extrinsic base region is protected by a mask during formation of the intrinsic base region, and since the effects of the first implantation are removed from the region in which the emitter and intrinsic base are to be formed, the intrinsic and extrinsic base regions are separately provided in order to yield the most ideal impurity profile.

Preferably the etching of said base region is made selective, e.g. by using $HF:HNO_3:CH_3COOH$ as etchant; that is, said base region is etched, but the etching stops at the interface between said base region and the wafer. This means that control is provided and the thickness of the wafer in the emitter region is not adversely affected by the etching step.

The emitter can be formed prior to or after the intrinsic base.

In this process, a single masking step provides the emitter and intrinsic base, which ensures that proper alignment of these regions with respect to each other and with respect to the extrinsic base region. The width of the window through which the emitter is formed is less than the width of the first implant or diffusion so that a doped, low resistance region will be left between the intrinsic and extrinsic base regions.

These and other objects, features, and advantages will be more apparent from the following more particular description of the preferred embodiments.

## Brief description of the drawings

Fig. 1.1 shows a cross section of a bipolar transistor (for example, an NPN transistor), while Figs. 1.2 and 1.3 show the preferred impurity concentration profiles of the intrinsic base region (Fig. 1.2) and extrinsic base region (Fig. 1.3) of this transistor.

Figs. 2—12 illustrate a process for making a bipolar transistor, in which the emitter and base contacts are self-aligned and in which the extrinsic and intrinsic base regions are formed by separate steps.

## Best mode for carrying out the invention

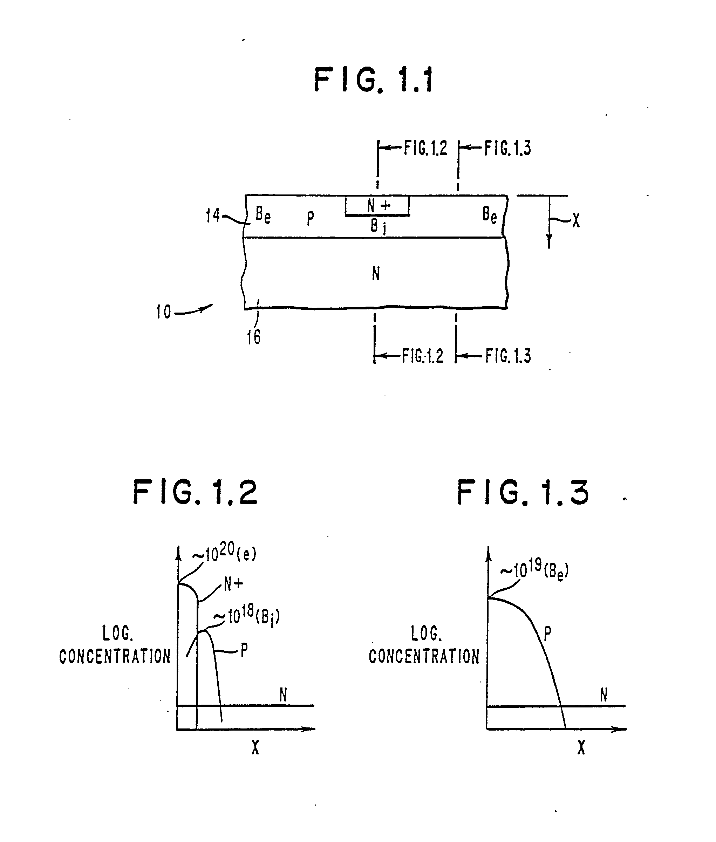

Fig. 1.1 shows a cross section of a bipolar transistor 10, having an $N^+$ region 12 (emitter), a P-type region 14 (base), and an N-type region 16 (collector). The region of base layer 14 below the emitter 12 is the intrinsic base region ($B_i$) while the regions of layer 14 surrounding emitter 12 are the extrinsic base regions ($B_e$).

Fig. 1.2 shows the preferred impurity concentration profile taken along the line 1.2—1.2 of Fig. 1.1. This is the impurity profile through the emitter 12, intrinsic base region $B_i$, and collector 16. A typical doping concentration in the emitter 12 is approximately $10^{20}$ carriers/cm$^3$, while a typical doping in the intrinsic base region is approximately $10^{18}$ carriers/cm$^3$. The intrinsic base doping profile is determined only by the desired intrinsic base characteristics, regardless of the extrinsic base profile. Usually, the intrinsic base doping level is less than that of the extrinsic base. The intrinsic base is formed by ion implantation, with minimum post ion implantion heat treatment in order to have a well controlled doping profile.

Fig. 1.3 shows the doping profile of the extrinsic base region $B_e$. A typical doping concentration is approximately $10^{19}$ carriers/cm$^3$. There is a high peak concentration in the extrinsic base region close to the surface of transistor 10 in order to reduce the extrinsic base resistance and to minimize emitter sidewall injection (i.e., to minimize injection of carriers from emitter region 12 into the extrinsic base region $B_e$).

In the prior art, the intrinsic and extrinsic base regions have been formed by separate steps, but the steps have been additive so that the ideal profiles shown in Figs. 1.2 and 1.3 have not been obtainable. The present invention describes a technique for closely approximating the profiles shown in Figs. 1.2 and 1.3, without an adverse effect upon formation of the emitter region 12.

Figs. 2—12

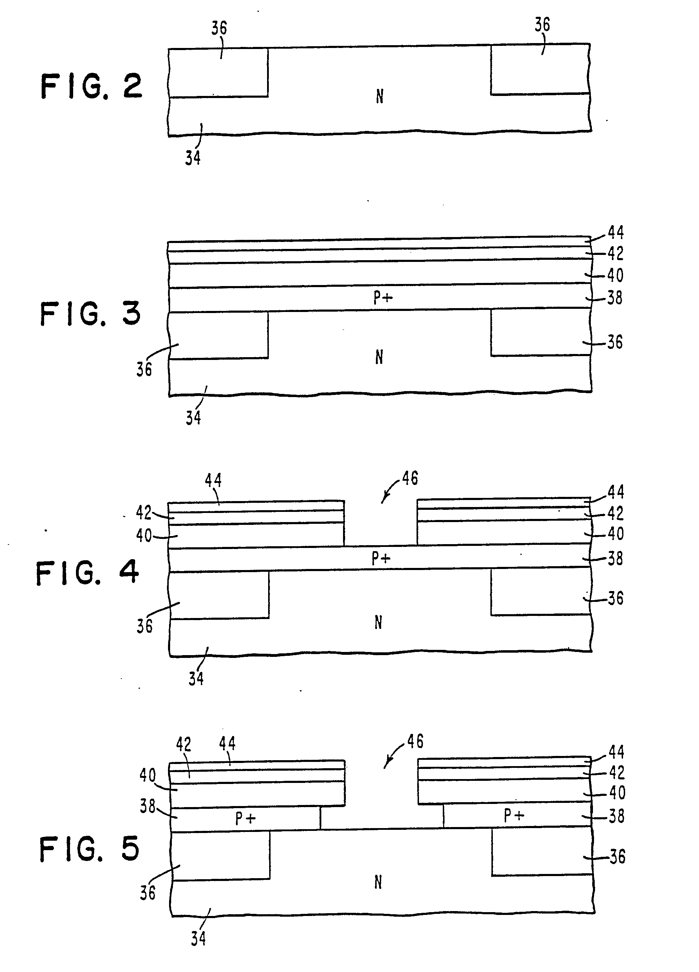

These figures illustrate a process in which the intrinsic and extrinsic base regions are provided by separate steps and in which the emitter and base contacts are self-aligned. In Fig. 2, a wafer of semiconductor 34, such as silicon, has recessed oxide regions 36 therein. Recessed oxide regions 36 provide isolation between devices. For ease of illustration, no subcollector is shown, although the provision of such is well known in the art.

In Fig. 3, a boron-doped $P^+$ layer 38 of polysilicon is deposited, followed by deposition of a first $SiO_2$ layer 40, a layer 42 of $Si_3N_4$, and a second layer 44 of $SiO_2$. Alternatively, the $Si_3N_4$ layer 42 and the $SiO_2$ layer 44 can be omitted if the $SiO_2$ layer 40 is sufficiently thick. Layer 38 is heavily doped to a concentration of about $10^{20}/cm^3$.

Fig. 4 shows the structure after the emitter window 46 has been delineated and formed through a mask. A suitable mask is a layer of reist (not shown) and the window 46 can be made by reactive ion etching of the layers 40, 42, and 44 in a mixture $CF_4$ and $H_2$. After the reactive ion etching, the resist layer is removed to leave the structure of Fig. 4. Alternatively, the layer 38 of polysilicon can be reactive ion etched partially in $CF_4$ prior to removing the resist layer.

In Fig. 5, $P^+$ layer 38 has been preferentially etched in a solution of $HF:HNO_3:CH_3COOH=1:3:8$. This etching occurs through window 46, and leaves an overhang in the emitter region.

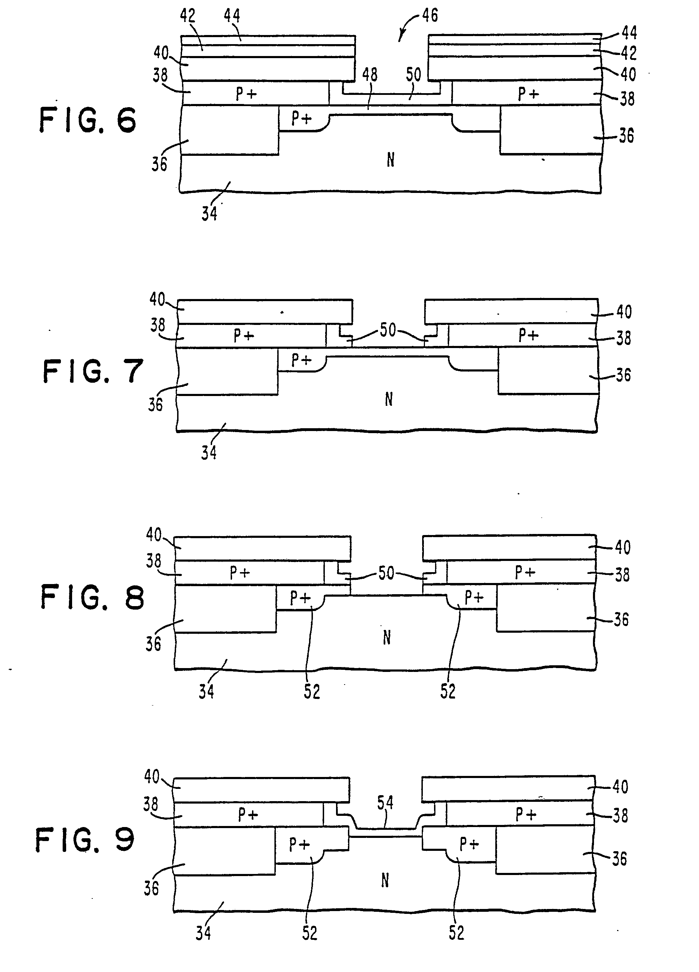

A thin $P^+$ layer 48 is then produced in the top surface of N-type wafer 34 by boron diffusion. After this, a layer 50 of $SiO_2$ is grown on the exposed surface of silicon wafer 34 and on the sidewall of the polysilicon layer 38. Alternatively, the layer 50 of $SiO_2$ can be a combination of thermally grown $SiO_2$ and chemically vapor deposited $SiO_2$. Some drive-in of the $P^+$ boron dopant in polysilicon layer 38 will occur during this step and, for this reason, the $P^+$ portions of layer 48 under polysilicon layer 38 are shown to a greater depth than the portion of layer 48 under $SiO_2$ layer 50. The resulting structure is shown in Fig. 6.

A reactive ion etching step in $CF_4$ and $H_2$ is then used to remove $SiO_2$ layer 50 in the emitter region. This step will also etch the $Si_3N_4$ layer 42 and the overlying $SiO_2$ layer 44. It will also remove a portion of the $SiO_2$ layer 40. The resulting structure is shown in Fig. 7.

Preferential etching of the $P^+$ layer 48 in the emitter region is then done, again using the mixture $HF:HNO_3:CH_3COOH=1:3:8$. This leaves the $P^+$ regions 52 (Fig. 8). An important feature of this process is that selective etching occurs; that is, doped layer 48 is etched, but the etching stops at the interface between layer 8 and N wafer 34. This means that control is provided and the thickness of wafer 34 in the emitter region is not adversely affected by the etching step.

A thin layer 54 of $SiO_2$ is then grown on the emitter region. Layer 54 serves as a screening oxide layer for later ion implantation in the emitter region. An annealing steps then occurs to drive in the extrinsic base, which is the $P^+$ regions 52. Thus, regions 52 have a greater depth in Fig. 9 than in Fig. 8.

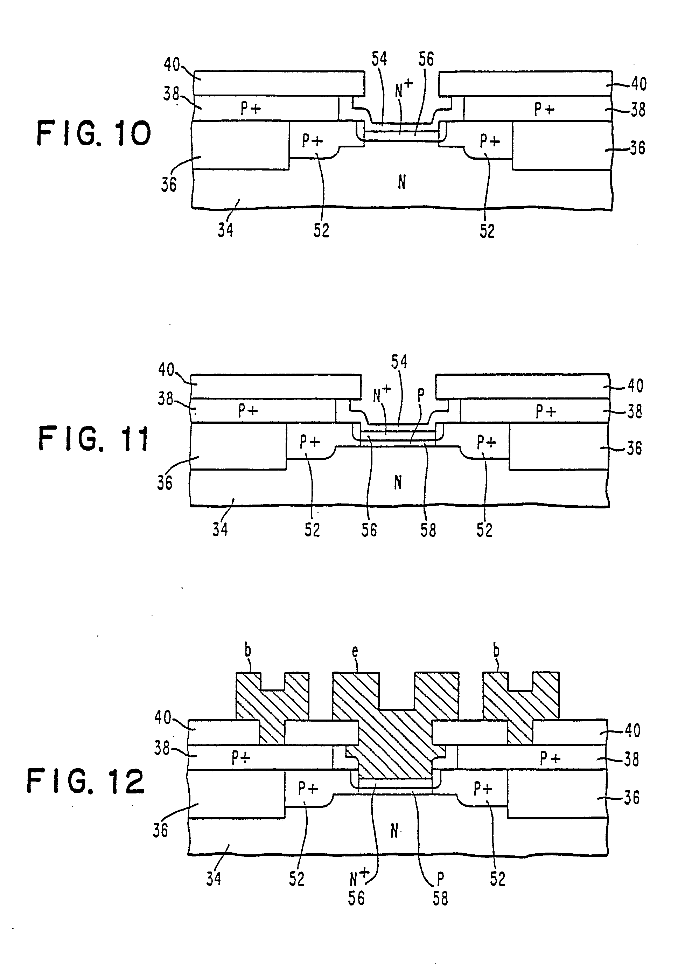

In Fig. 10, arsenic is ion implanted and driven in to form the $N^+$ region 56. Region 56 is the emitter of the device. Alternatively, the drive-in step may be postponed until the intrinsic base has been implemented.

In Fig. 11, the intrinsic base region is formed by ion implantation of boron, which is driven in to provide P-type region 58. Alternatively, the sequence for forming the emitter and the intrinsic base may be reversed so that the intrinsic base region may be formed prior to formation of the emitter.

In Fig. 12, contact locations are delineated, and contact holes are opened to the polysilicon layer 38. After this, dip-etching occurs to remove $SiO_2$ layer 54 on the emitter. A metal layer is then deposited and delineated to form the base contacts b and the emitter contact e.

In the process illustrated by Figs. 2—12, the emitter and base regions are self-aligned with one another, since a polysilicon layer 38 is used to provide base contact and as a mask when forming the emitter.

As described previously, selective etching of the $P^+$ silicon in the emitter region does not contaiminate the silicon surface and no exposed or depleted surface regions result.

What has been described is a process wherein an ideal doping profile can be approximated without adverse effects on other portions of the transistor. In addition to providing two steps for forming the extrinsic and intrinsic regions, the process completely separates the fabrication of these two regions so that the desired characteristics of each can be enhanced. This is done in a manner which leaves a low resistance bridge between the intrinsic and extrinsic base regions, and in a manner which provides good process control. That is, the thickness of the semiconductor wafer can be established beforehand without having to allow extra thickness for etching, etc. The selective etching step does not attack the underlying semiconductor, and therefore its thickness can be determined with regard to only the desired electrical characteristics of the device. This is the key to a practical process and is a step which was not appreciated in the art. Still further, there is a self-alignment between the emitter and extrinsic/intrinsic base regions since the same mask is used to define the emitter and intrinsic base region, after formation of the extrinsic base.

It will be understood by those of skill in the art that diffusion or ion implantation can be used to provide the extrinsic base regions, the emitter regions, and also the intrinsic base regions. Also, both NPN and PNP transistors can be fabricated in different semiconductor materials, including silicon, germanium, and gallium arsenide.

## Claims

1. A method for forming a transistor in a wafer of semiconductor material having a collector region (34) therein of a first conductivity type, including the steps of:
   forming a doped polycrystalline layer (38) of said semiconductive material of the opposite conductivity type to said collector region over a surface of said semiconductor wafer,
   forming a base region (48) of opposite conductivity type to said first conductivity type in said wafer of semiconductor material, portions of said base region being extrinsic base regions of said transistor,
   masking a portion of said base region to expose an area thereof to be removed by an etching step,
   etching said base region in said exposed area to remove said base region in said exposed area, creating a window therein, thereby exposing a portion of said surface of said semiconductor wafer, there being a portion of said base region left which is said extrinsic base region,
   forming an emitter region (56) and an intrinsic base region (58) through said window in said base region, said emitter having the same conductivity type as said collector, said intrinsic base region having the same conductivity type as said extrinsic base region,
   opening contact holes to said layer (38) of polycrystalline semiconductor material, and
   contacting said extrinsic base region by metal contacts which contact said layer of polycrystalline material, and depositing a metal layer which electrically contacts said emitter region.

2. The method of claim 1, where said semiconductor material is silicon and said layer of doped semiconductor material is a polycrystalline layer of silicon.

3. The method of claim 1, where said collector and emitter regions are N-type and said base is P-type.

4. The method of claim 1, where said collector and emitter regions are P-type and said base regions are N-type.

5. The method of claim 1, where said etching step selectively etches said region of opposite conductivity type and not said underlying semiconductor wafer.

6. The method of claim 1, where said emitter is formed prior to formation of said intrinsic base region.

7. The method of claim 1, where said intrinsic base region is formed prior to formation of said emitter region.

8. The method of claim 1, where said intrinsic and extrinsic base regions are formed by ion implantation.

9. The method of claim 1, where said extrinsic base region is formed by diffusion.

10. The method of claim 1, where said extrinsic base region is protected during formation of said intrinsic base region and said emitter region.

## Patentansprüche

1. Verfahren zum Bilden eines Transistors mit einem Kollektorbereich (34) eines ersten Leitfähigkeitstyps in einem Wafer aus Halbleitermaterial, einschließend die folgenden Schritte:
   Bilden einer dotierten polykristallinen Schicht (38) aus dem gennten Halbleitermaterial eines Leitfähigkeitstyps entgegengesetzt dem des erwähnten Kollektorbereichs auf einer Oberfläche des Halbleiterwafers,
   Ausbilden einer Basiszone (48) mit einem Leitfähigkeitstyp entgegengesetzt dem des ersten Leitfähigkeitstyps in der Halbleiterscheibe, wobei Teile dieser Basiszone extrinsische Basiszonen des Transistors sind,
   Herstellen einer Maske über einem Teil der Basiszone, wobei ein durch einen Ätzschritt zu entfernender Bereich freigelegt bleibt,
   Ätzen der Basiszone im freigelegten Bereich zur Entfernung der Basiszone im freigelegten Bereich, unter Bildung eines Fensters, wodurch ein Teil der Oberfläche der Halbleiterscheibe freigelegt wird und ein Teil der Basiszone übrig bleibt, bei welcher es sich um die extrinsische Basiszone handelt,
   Ausbilden einer Emitterzone (56) und einer intrinsischen Basiszone (58) durch das Fenster in der Basiszone, wobei der Emitter vom gleichen Leitfähigkeitstyp wie der Kollektor ist, und wobei die intrinsische Basiszone vom gleichen Leitfähigkeitstyp wie die extrinsische Basiszone ist,
   Öffnen von Kontaktöffnungen zur Schicht (38) aus polykristallinem Halbleitermaterial, und
   Kontaktieren der extrinsischen Basiszone mit Metallkontakten, welche die Schicht aus polykristallinem Material berühren, und Aufbringen einer Matallschicht, welche die Emitterzone elektrisch kontaktiert.

2. Verfahren nach Anspruch 1, worin das Halbleitermaterial Silicium und die Schicht aus dotiertem Halbleitermaterial eine polykristalline Siliciumschicht ist.

3. Verfahren nach Anspruch 1, worin Kollektor- und Emitterzonen vom N-Typ und die Basis vom P-Typ ist.

4. Verfahren nach Anspruch 1, worin Kollektor- und Emitterzonen vom P-Typ und die Basiszone vom N-Typ ist.

5. Verfahren nach Anspruch 1, worin im Ätzschritt die genannte Zone vom entgegengesetzten Leitfähigkeitstyp und nicht der darunterliegende Halbleiterwafer geätzt wird.

6. Verfahren nach Anspruch 1, worin der Emitter vor der Bildung der intrinsischen Basiszone hergestellt wird.

7. Verfahren nach Anspruch 1, worin die intrinsische Basiszone vor der Bildung der Emitterzone gebildet wird.

8. Verfahren nach Anspruch 1, worin die intrinsischen und extrinsischen Basiszonen durch Ionenimplantation gebildet werden.

9. Verfahren nach Anspruch 1, worin die extrinsische Basiszone durch Diffusion gebildet wird.

10. Verfahren nach Anspruch 1, worin die extrinsische Basiszone während der Bildung der intrinsischen Basiszone und der Emitterzone geschützt wird.

**Revendications**

1. Une méthode de formation d'un transistor dans une tranche de matériau semiconducteur présentant une région de collecteur (34) d'un premier type de conductivité, comprenant les étapes suivantes:

la formation d'une couche polycristalline dopée (38) dudit matériau semi-conducteur du type de conductivité opposée à celle de ladite région de collecteur, sur une surface de ladite tranche semi-conductrice,

la formation d'une région de base (48) du type de conductivité opposée audit premier type de conductivité dans ladite tranche de matériau semi-conducteur, des parties de ladite région de base étant des régions de base extrinsèques dudit transistor,

le masquage d'une partie de ladite région de base afin d'exposer une zone de celle-ci à retirer par exécution d'une étape de décapage,

le décapage de ladite région de base dans ladite zone exposée pour retirer ladite région de base dans ladite zone exposée afin de créer une fenêtre, ce qui expose une partie de ladite surface de ladite tranche semi-conductrice, ce qui laisse une partie de ladite région de base qui constitue la dite région de base extrinsèque,

la formation d'une région d'émetteur (56) et d'une région de base intrinsèque (58) au travers de ladite fenêtre dans ladite région de base, ledit émetteur ayant le même type de conductivité que ledit collecteur, ladite région de base intrinsèque ayant le même type de conductivité que ladite région de base extrinsèque,

l'ouverture de trous de contact à ladite couche (38) de matériau semi-conducteur polycristallin, et

la mise en contact de ladite région de base extrinsèque par des contacts de métal qui contactent ladite couche de matériau polycristallin et le dépôt d'une couche de métal qui contacte électriquement ladite région d'émetteur.

2. La méthode de la revendication 1 dans laquelle ledit matériau semi-conducteur est du silicium et ladite couche de matériau semi-conducteur dopé est une couche polycristalline de silicium.

3. La méthode de la revendication 1 dans laquelle lesdites régions de collecteur et d'émetteur sont du type N-et ladite base, du type P-.

4. La méthode de la revendication 1 dans laquelle lesdites régions de collecteur et d'émetteur sont du type P- et lesdites régions de base, du type N-.

5. La méthode de la revendication 1 dans laquelle ladite étape de décapage assure le décapage sélectif de ladite région du type de conductivité opposée et non celui de ladite tranche semi-conductrice sous-jacente.

6. La méthode de la revendication 1 dans laquelle ledit émetteur est formé avant la formation de ladite région de base intrinsèque.

7. La méthode de la revendication 1 dans laquelle ladite région de base intrinsèque est formée avant la formation de ladite région d'émetteur.

8. La méthode de la revendication 1 dans laquelle lesdites régions de base intrinsèque et extrinsèque sont formées par implantation d'ions.

9. La méthode de la revendication 1 dans laquelle ladite région de base extrinsèque est formée par diffusion.

10. La méthode de la revendication 1 dans laquelle ladite région de base extrinsèque est protégée pendant la formation de ladite région de base intrinsèque et de ladite région d'émetteur.

# FIG. 1.1

# FIG. 1.2

# FIG. 1.3

**FIG. 2**

**FIG. 3**

**FIG. 4**

**FIG. 5**

FIG. 6

42  44  46

40

38

P+  48  50  P+

36

P+

N

36

34

FIG. 7

40

38

P+  50  P+

36

P+

N

36

34

FIG. 8

40

38

P+  50  P+

36

P+  P+

N

36

34  52  52

FIG. 9

40

38

P+  54  P+

36

P+  P+

N

36

34  52  52

FIG. 10

40
38
P+
36
36
34
52
N
54 56
N⁺
P+
P+
40
38
36
P+
52

FIG. 11

40
38
P+
36
36
34
52
54
N⁺ P
56 58
P+
P+
N
52
40
38
36
P+

FIG. 12

b
e
b
40
38
P+
36
36
34
52
N⁺ P
56 58
P+
52
N
P+
40
38
36
P+